# EUROPÄISCHE PATENTSCHRIFT

(11) **EP 1 248 968 B1**
(45) Veröffentlichungstag und Bekanntmachung des Hinweises auf die Patenterteilung: **10.09.2003**
(21) Anmeldenummer: 01272607.1
(22) Anmeldetag: 24.10.2001
(51) Int. Cl.: G05D 23/24

(54) **ANORDNUNG ZUR TEMPERATURMESSUNG UND -REGELUNG**
ARRANGEMENT FOR TEMPERATURE MONITORING AND REGULATION
DISPOSITIF DE MESURE ET DE REGULATION DE TEMPERATURE

(30) Priorität: 29.12.2000 DE 10065723
(43) Veröffentlichungstag der Anmeldung: 16.10.2002
(73) Patentinhaber: ROBERT BOSCH GMBH, 70442 Stuttgart (DE)
(72) Erfinder: HEINE, Frank, 74533 Mainhardt (DE); BARTELT-BERGER, Lars, 71522 Backnang (DE); SMUTNY, Berry, 71522 Backnang (DE)
(74) Vertreter: Schuster, Gregor, Dipl.-Ing.
(86) Internationale Anmeldenummer: DE0104043
(87) Internationale Veröffentlichungsnummer: WO02054166

(56) Entgegenhaltungen:
- EP-A- 0 036 042
- EP-A- 0 094 266
- EP-A- 0 465 914
- PATENT ABSTRACTS OF JAPAN vol. 008, no. 072 (P-265), 4. April 1984 (1984-04-04) & JP 58 217022 A (MATSUSHITA DENKO KK), 16. Dezember 1983 (1983-12-16)

## Beschreibung

### Stand der Technik

Die Erfindung geht aus von einer Anordnung zur Temperaturmessung und -regelung mit einem Temperaturmeßwiderstand und einem Stellelement.

Zur hochgenauen und langzeitstabilen Temperaturmessung werden Metallschichtwiderstände, insbesondere Platindünnschichtwiderstände verwendet. Der Grund dafür ist die relativ starke Temperaturabhängigkeit des spezifischen elektrischen Widerstandes von Platin und dessen hohe chemische und physikalische Resistenz. Die Eigenschaften für technische Platinwiderstände zur Temperaturmessung sind in der DIN IEC 751 festgelegt.

Ein verbreitetes und auch großtechnisch eingesetztes Fertigungsverfahren ist das Aufdampfen einer Metallschicht, z. B. Platin, auf Keramiksubstrate, das eine genaue Kontrolle der Schichtdicke und damit des Widerstandes für eine gegebene Struktur ermöglicht. Dieser Dünnschicht kann nachfolgend durch Maskierung und Ätzen in der Fläche die gewünschte Form gegeben werden. Um einen absolut kalibrierten und hochgenauen Widerstand zu erhalten, ist die Trimmung der geätzten Widerstandstruktur notwendig. Diese Trimmung wird z. B. mit Hilfe von Laserablation durchgeführt.

Das beschriebene Verfahren liefert hochgenaue und langzeitstabile Temperaturmeßwiderstände. Durch den Einsatz von Herstellungsprozessen, die denen der Halbleiterindustrie gleichen, sind kleinste Bauformen und Strukturen der Flächenwiderstände realisierbar. Gegeben durch die Fertigungstechnik ist die Form der Metallschichtwiderstände in der Fläche des Substrates relativ frei. Um zu möglichst kleinen Bauformen bei gegebenem Sollwiderstand für eine Temperatur und zu einfachen Trimmalgorithmen zu kommen, werden die Widerstände üblicherweise mäanderförmig strukturiert.

Die elektrische Kontaktierung der Dünnschichtwiderstände wird über an Kontaktflächen gelötete, gebondete oder geschweißte Kontaktdrähte realisiert.

Um eine Temperaturregelung zu realisieren ist die Kombination eines Temperaturmeßwiderstandes mit einem Stellelement notwendig. Dieses Stellelement kann z. B. ein Peltier-Element oder für langzeitstabile Anwendung ein Widerstandsheizelement sein.

### Vorteile der Erfindung

Mit den Maßnahmen des Anspruchs 1 ist eine hochstabile und hochgenaue Temperaturregelung von vorzugsweise planaren Bauteilen möglich. Durch die direkte Nachbarschaft von Temperaturmeßwiderstand und Stellelement auf einem gemeinsamen Substrat in einer Schicht mit den entsprechenden Leiterzügen in unmittelbarer Nähe, wird die Temperaturdifferenz zwischen dem Temperaturmeßwiderstand und dem Stellelement minimiert. Dadurch kann höchste Absolutgenauigkeit bei der Messung der Temperatur des Stellelements erreicht werden.

Durch die Integration von Stellelement und Temperaturmeßwiderstand auf einem gemeinsamen planaren Substrat wird zusätzlich der Aufwand beim Aufbau einer Temperaturregelung durch die Reduktion der Anzahl von Bauteilen reduziert. Dies ist besonders für eine automatisierte planare hybride Aufbautechnik wichtig.

Da Stellelement und Temperaturmeßwiderstand in einem gemeinsamen Fertigungsablauf realisiert werden, kommt es über die technischen Vorteile hinaus zu einer Kostenreduktion.

Für die Herstellung der vorgeschlagenen Anordnung können konventionelle Fertigungsmethoden für Metalldünnschichtwiderstände eingesetzt werden.

Der Kern der Erfindung ist die eng benachbarte Kombination von zwei Metallschichtwiderständen auf einem vorzugsweise planaren Substrat. Einem der Metallschichtwiderstände wird die Funktion eines Stellelements zugeordnet, der zweite Metallschichtwiderstand dient als Temperaturmeßwiderstand.

Die Vorteile der beschriebenen Kombination von Metallschichtwiderständen sind:
- der minimierte räumliche Abstand zwischen Stellelement und Temperaturmeßwiderstand minimiert die Temperaturdifferenz zwischen beiden Metallschichtwiderständen. Dadurch wird eine höchstmögliche Genauigkeit bei der Messung der absoluten Temperatur des Stellelements erreicht,
- durch den minimierten räumlichen Abstand wird die Zeit zwischen einer Temperaturänderung des Stellelements und der des Temperaturmeßwiderstands minimiert. Dies erhöht die Stabilität einer elektronischen Regelung, die einen der Metallschichtwiderstände als Stellelement und den anderen als Temperaturmeßwiderstand verwendet (Totzeitminimierung),
- durch die Integration von zwei Funktionen in einem Bauteil reduziert sich der notwendige Raumbedarf für Stellelement und Temperaturmeßwiderstand (Temperatursensor einer Temperaturregelung). Dies kann für sehr kleine Bauteile mit Kantenlängen von wenigen Millimetern die einzig mögliche Realisierung einer hochstabilen Temperaturregelung sein,
- durch die Integration von zwei Funktionen mit der gleichen Technik auf einem Substrat reduziert sich der Fertigungsaufwand und damit die Kosten,
- das Wegfallen einer Fügestelle zwischen Stellelement und Temperaturmeßwiderstand erhöht die Langzeitstabilität der Temperaturmessung und -regelung. Dies ist besonders bei extremen Umweltbedingungen sehr wichtig (große Temperaturbereiche, Vakuum, radioaktive Strahlung, chemische Belastungen),
- als planares Bauteil ausgeführt, ist die Kombination von Stellelement und Temperaturmeßwiderstand kompatibel zur planaren hybriden Aufbautechnik. Damit ist die Integration eines solchen Bauteils mit automatisierter Fertigungstechnik leicht möglich.

Durch die Anordnung gemäss Anspruch 2 erfahren die Leiterzüge von Temperaturmeßwiderstand und Stellelement genau denselben Temperaturgang, was zur exakten Temperaturerfassung und -regelung beiträgt.

Durch die Maßnahmen der Ansprüche 3, 4 und 8 ist der Temperaturgradient zwischen Bauteil und Temperaturmeßwiderstand vernachlässigbar und es stellt sich keine Totzeit zwischen Stellgröße und Istwert ein, die zu einer reduzierten Reglerstabilität führen könnte.

Mit Anspruch 5 kann das Stellelement wie der Temperaturmeßwiderstand ausgebildet sein, mit dem einzigen Unterschied, dass er zu seiner Heizung mit einem Heizstrom beaufschlagt wird.

Gemäss Anspruch 6 kann die Herstellung des Temperaturmeßwiderstandes und des Stellelements durch Aufdampfen in einem Arbeitsgang erfolgen.

Durch das Aufbringen einer isolierenden Schutzschicht auf die beiden Leiterzüge gemäss Anspruch 7 erhält man eine größere Freiheit bei der Fügung der Stellelement/Temperatursensor-Kombihation mit einem zu temperierenden Bauteil.

Anspruch 9 stellt eine einfache Abgleichmöglichkeit insbesondere zur Erreichung normgerechter Kennwerte für den Temperaturmeßwiderstand zur Verfügung.

Anspruch 10 zeigt eine vorteilhafte Verwendungsmöglichkeit der erfindungsgemäßen Anordnung für Resonatoren auf.

### Zeichnungen

Anhand der Zeichnungen werden Ausführungsbeispiele erläutert. Es zeigen
Figur 1 eine Anordnung zur Temperaturregelung konventioneller Art,
Figur 2 eine Aufsicht auf eine erfindungsgemäße Anordnung,
Figur 3 einen Schnitt durch die Anordnung gemäss Figur 2,
Figur 4 eine Aufsicht auf eine modifizierte Anordnung nach der Erfindung,
Figur 5 einen Schnitt durch die Anordnung gemäss Figur 4.

### Beschreibung von Ausführungsbeispielen

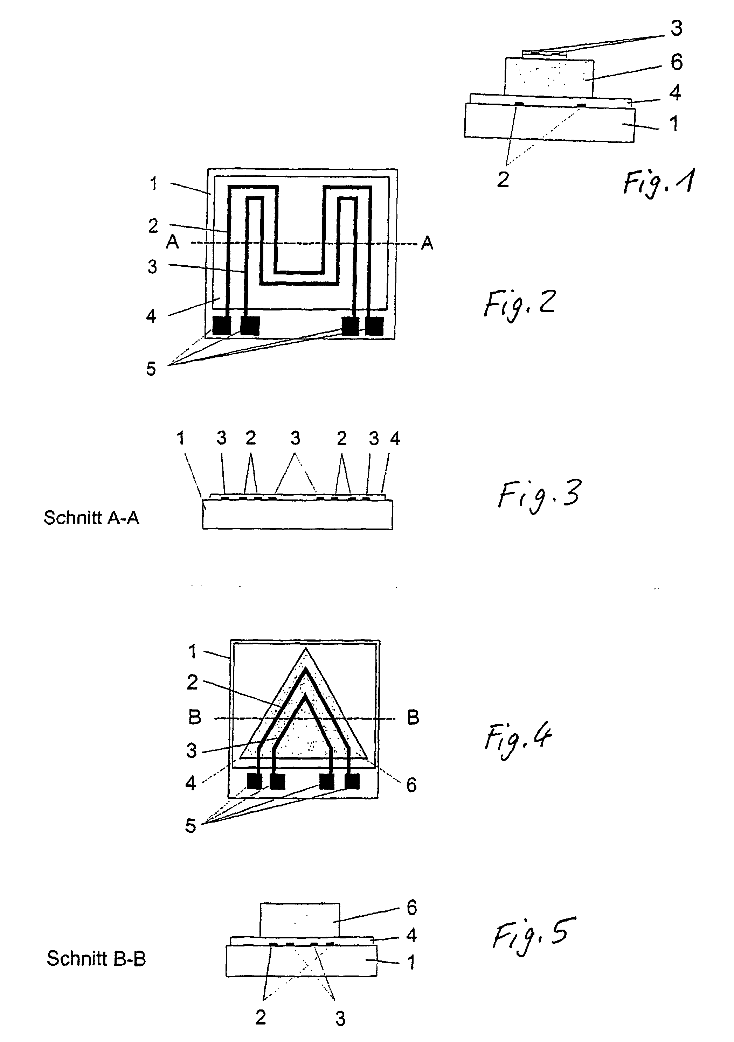

Bevor die eigentliche erfindungsgemäße Anordnung beschrieben wird, soll auf eine konventionelle Anordnung zur Temperaturmessung und -regelung eingegangen werden. Figur 1 zeigt eine solche konventionelle Anordnung. Für ein Bauteil 6 soll die Temperatur erfaßt werden und eine Temperaturregelung erfolgen. Zur Temperaturerfassung ist ein Temperatursensor 3 auf der Oberseite des Bauteils 6 vorgesehen. Die Unterseite des Bauteils 6 ist mit einem Stellelement 2 in Form eines Heizwiderstandes versehen, der auf ein Substrat 1 aufgebracht wurde und mit einer isolierenden Schicht 4 abgedeckt ist.

Durch den räumlichen Abstand zwischen Stellelement 2 und Temperatursensor 3 kommt es zu einem Temperaturgradienten zwischen Sensor und Stellelement und damit zu einer entsprechenden Ungenauigkeit der Temperaturmessung. Durch den räumlichen Abstand kommt es darüber hinaus zu einer Totzeit zwischen Stellgröße und Istwert, die zu einer reduzierten Reglerstabilität führt.

Figur 2 zeigt ein Ausführungsbeispiel einer erfindungsgemäßen Anordnung. Temperaturmeßwiderstand 3 und Stellelement 2 sind als Metallisierung auf einem Substrat 1 in einer gemeinsamen Schicht untergebracht. Als Substrat eignet sich ein Aluminiumoxid-Substrat. Die streifenartigen Leiterzüge von Temperaturmeßwiderstand 3 und Stellelement 2 sind in unmittelbarer Nähe zueinander angeordnet und verlaufen im Wesentlichen parallel zueinander und sind mäanderförmig geführt. Das Stellelement 2 weist vorzugsweise eine Metallwiderstandsschicht aus dem gleichen Material auf, wie die Metallwiderstandsschicht des Temperaturmeßwiderstandes. Die einzigen Unterschiede des Stellelements gegenüber dem Temperaturmeßwiderstand liegen darin, dass die Widerstandsschicht des Stellelements 2 mit einer elektrischen Spannung beaufschlagt wird und sich damit erhitzen kann und eine je nach der gewünschten Stellkennlinie unterschiedliche Widerstandsdimensionierung, z. B. 10 - 100 Ω für das Stellglied 2 und etwa 1000 Ω für den Temperaturmeßwiderstand 3.

Die beiden Widerstandsschichten werden mit Hilfe bekannter Technik auf das Substrat 1 aufgebracht, z. B. aufgedampft. Die elektrische Kontaktierung der Widerstandsschichten von Temperaturmeßwiderstand 3 und Stellglied 2 geschieht über die Kontakte 5, die löt-, bond- oder schweißbar ausgeführt sein können. Zum Schutz der dünnen Metallwiderstandsschichten 2 und 3 kann eine passivierende Schutzschicht 4 aufgebracht werden. Diese Schicht ermöglicht eine größere Freiheit bei der Fügung der
Heizelement/Temperatursensor-Kombination mit einem zu temperierenden Bauteil 6 (siehe Schnittdarstellung in Figur 5).

An die Kontakte des Stellelements 2 (Heizwiderstandes) wird eine elektrische Spannung angelegt. Aus dem fließenden Strom und der über dem Heizwiderstand abfallenden Spannung ergibt sich die Heizleistung, mit dem ein Bauteil 6 und das Substrat 1 erwärmt wird. Die Temperatur in der Ebene der Substratoberfläche wird mit dem Temperaturmeßwiderstand erfaßt. In Abhängigkeit der Widerstandstemperatur stellt sich ein definierter Widerstand ein (für Platin-Metallschichtwiderstände vgl. DIN IEC 751). Der Widerstandswert kann mit hoher Präzision über eine Brückenschaltung stromlos gemessen werden.

Die Form und Lage der Metallwiderstände 2 und 3 sind innerhalb der Ebene praktisch frei wählbar, da sie mit der eingangs erwähnten Aufdampftechnik hergestellt werden. Es ist nur die Herstellung entsprechender Masken notwendig, und darauf zu achten, dass es zu keiner Überlappung der Leiterzüge des Stellelements 2 und des Temperaturmeßwiderstandes 3 kommt.

Durch diesen Design-Freiheitsgrad ist die Anpassung der Form der Widerstände an die Geometrie eines gegebenen zu temperierenden Bauteils 6 möglich. Die Anpassung der Heizwiderstandsgeometrie an das Bauteil kann zu einer möglichst homogenen Erwärmung des Bauteils genutzt werden. Die Meßwiderstandsgeometrie kann so angepaßt werden, dass möglichst die mittlere Temperatur des Bauteils 6 erfaßt wird.

Um normgerechte Kennwerte für den Meßwiderstand zu erreichen, ist es zusätzlich möglich, Abgleichstrukturen auf dem Substrat unterzubringen. Diese Abgleichstrukturen können innerhalb oder außerhalb der Grundfläche des Bauteils 6 auf dem Substrat 1 liegen.

Durch die Anordnung von Heiz- und Meßwiderstand in einer Ebene kann die Temperatur dieser Ebene hochgenau gemessen werden. Um zu gewährleisten, dass die Temperatur des Bauteils 6 gleich der Meßebene entspricht, muss das Bauteil zur restlichen Umgebung thermisch isoliert sein. Zusätzlich muss gewährleistet sein, dass das Bauteil 6 selbst keine Wärmequelle ist. Treffen diese Bedingungen nicht zu, kommt es zu einer Temperaturdifferenz zwischen dem Bauteil 6 und dem Temperaturmeßwiderstand 3.

Während die in den Figuren 2 und 3 dargestellte Anordnung mäanderförmig ausgestaltete Leiterzüge für Temperaturmeßwiderstand 3 und Stellglied 2 aufweist, ist die Anordnung der Leiterzüge in den Figuren 4 und 5 dreiecksförmig, da das unmittelbar auf der Schicht der Leiterzüge von Temperaturmeßwiderstand 3 und Stellelement 2, beziehungsweise auf der diese abdeckenden Schicht 4 aufgebrachte Bauteil 6 ebenfalls dreiecksförmig ausgebildet ist.

Mögliche Bauteile 6 für die eine hochgenaue Temperaturregelung notwendig sein kann, sind Resonatoren optischer (Laserkristalle) oder elektrischer (Quarze) Bauart. Die Eigenfrequenz solcher Resonatoren hängt von ihren geometrischen Dimensionen und über die Wärmeausdehnung damit auch von ihrer Temperatur ab. Für eine hochgenaue absolute Frequenzstabilisierung ist damit die Kontrolle der absoluten Temperatur dieser Bauteile wesentlich.

## Patentansprüche

1. Anordnung zur Temperaturmessung und -regelung mit einem Temperaturmeßwiderstand und einem Stellelement mit folgenden Maßnahmen:
- Temperaturmeßwiderstand (3) und Stellelement (2) sind als Metallisierung auf einem Substrat (1) in einer Schicht untergebracht,
- die Leiterzüge von Temperaturmeßwiderstand (3) und Stellelement (2) sind in unmittelbarer Nähe zueinander angeordnet.

2. Anordnung nach Anspruch 1, **dadurch gekennzeichnet, dass** die Leiterzüge von Temperaturmeßwiderstand (3) und Stellelement (2) streifenartig ausgebildet sind und im Wesentlichen parallel zueinander angeordnet sind.

3. Anordnung nach Anspruch 1 oder 2, **dadurch gekennzeichnet, dass** der Verlauf der Leiterzüge von Temperaturmeßwiderstand (3) und Stellelement (2) an die Geometrie des zu temperierenden Bauteils angepaßt sind.

4. Anordnung nach einem der Ansprüche 1 bis 3, **dadurch gekennzeichnet, dass** die Geometrie des Leiterzuges des Temperaturmeßwiderstandes (3) derart gewählt ist, dass die mittlere Temperatur des zu tempererierenden Bauteiles (6) erfaßbar ist.

5. Anordnung nach einem der Ansprüche 1 bis 4, **dadurch gekennzeichnet, dass** das Stellelement (2) als heizbarer Widerstand ausgebildet ist.

6. Anordnung nach einem der Ansprüche 1 bis 5, **dadurch gekennzeichnet, dass** die Leiterzüge von Temperaturmeßwiderstand (3) und Stellelement (2) aus einer auf das Substrat (1) aufgedampften Metallschicht bestehen.

7. Anordnung nach einem der Ansprüche 1 bis 6, **dadurch gekennzeichnet, dass** die Leiterzüge von Temperaturmeßwiderstand (3) und Stellelement (2) mit einer isolierenden Schicht (4) abgedeckt sind.

8. Anordnung nach einem der Ansprüche 1 bis 7, **dadurch gekennzeichnet, dass** das zu temperierende Bauteil (6) unmittelbar auf der Schicht der Leiterzüge von Temperaturmeßwiderstand (3) und Stellelement (2) beziehungsweise auf der diese abdeckende isolierende Schicht (4) aufgebracht ist.

9. Anordnung nach einem der Ansprüche 1 bis 8, **dadurch gekennzeichnet, dass** auf dem Substrat (1) Abgleichstrukturen für den Leiterzug des Temperaturmeßwiderstandes (3) vorgesehen sind.

10. Verwendung der Anordnung nach einem der Ansprüche 1 bis 9 zur Temperaturregelung von Resonatoren optischer oder elektrischer Bauart.

## Claims

1. Arrangement for temperature monitoring and regulation with a temperature-sensitive resistor and a control element with the following measures:
- temperature-sensitive resistor (3) and control element (2) are accommodated in a layer as a metallic coating on a substrate (1),
- the printed conductors of temperature-sensitive resistor (3) and control element (2) are arranged in immediate proximity to each other.

2. Arrangement according to claim 1, **characterised in that** the printed conductors of temperature-sensitive resistor (3) and control element (2) are configured in strip form and are essentially arranged in parallel with each other.

3. Arrangement according to claim 1 or 2, **characterised in that** the characteristic of the printed conductors of temperature-sensitive resistor (3) and control element (2) is adapted to the geometry of the component to be tempered.

4. Arrangement according to one of claims 1 to 3, **characterised in that** the geometry of the printed conductor of the temperature-sensitive resistor (3) is chosen in such a way that the mean temperature of the component (6) to be tempered can be recorded.

5. Arrangement according to one of claims 1 to 4, **characterised in that** the printed element (2) is configured as a heatable resistor.

6. Arrangement according to one of claims 1 to 5, **characterised in that** the printed conductors of temperature-sensitive resistor (3) and control element (2) consist of a metal coat vapour-deposited on the substrate (1).

7. Arrangement according to one of claims 1 to 6, **characterised in that** the printed conductors of temperature-sensitive resistor (3) and control element (2) are covered with an insulating layer (4).

8. Arrangement according to one of claims 1 to 7, **characterised in that** the component (6) to be tempered is accommodated directly on the coat of the printed conductors of temperature-sensitive resistor (3) and control element (2) respectively on the insulating layer (4) covering them.

9. Arrangement according to one of claims 1 to 8, **characterised in that** compensating structures for the printed conductor of the temperature-sensitive resistor (3) are provided on the substrate (1).

10. Use of the arrangement according to one of claims 1 to 9 for the temperature regulation of resonators of an optical or electrical design.

## Revendications

1. Dispositif pour la mesure et le réglage de la température avec une résistance de mesure de température et un élément de commande avec les mesures suivantes :
- La résistance de mesure de température (3) et l'élément de commande (2) sont logés en tant que métallisation sur un substrat (1) dans une couche,
- les circuits conducteurs de la résistance de mesure de température (3) et de l'élément de commande (2) sont disposés à proximité immédiate les uns les autres.

2. Dispositif selon la revendication 1, **caractérisé en ce que** les circuits conducteurs de la résistance de mesure de température (3) et de l'élément de commande (2) sont conçus en forme de bande et sont disposés de façon sensiblement parallèle entre eux.

3. Dispositif selon la revendication 1 ou 2, **caractérisé en ce que** le tracé des circuits conducteurs de la résistance de mesure de température (3) et de l'élément de commande (2) sont adaptés à la géométrie du composant à tempérer.

4. Dispositif selon l'une quelconque des revendications 1 à 3, **caractérisé en ce que** la géométrie du circuit conducteur de la résistance de mesure de température (3) est choisie de telle sorte que la température moyenne du composant (6) à tempérer peut être enregistrée.

5. Dispositif selon l'une quelconque des revendications 1 à 4, **caractérisé en ce que** l'élément de commande (2) est conçu comme une résistance chauffante.

6. Dispositif selon l'une quelconque des revendications 1 à 5, **caractérisé en ce que** les circuits conducteurs de la résistance de mesure de température (3) et de l'élément de commande (2) sont à base d'une couche métallique métallisée par évaporation sur le substrat (1).

7. Dispositif selon l'une quelconque des revendications 1 à 6, **caractérisé en ce que** les circuits conducteurs de la résistance de mesure de température (3) et de l'élément de commande (2) sont recouverts avec une couche isolante (4).

8. Dispositif selon l'une quelconque des revendications 1 à 7, **caractérisé en ce que** le composant (6) à tempérer est appliqué directement sur la couche des circuits conducteurs de la résistance de mesure de température (3) et de l'élément de commande (2) et sur la couche isolante (4) recouvrant cette couche.

9. Dispositif selon l'une quelconque des revendications 1 à 8, **caractérisé en ce qu'**il est prévu sur le substrat (1) des structures d'équilibrage pour le circuit conducteur de la résistance de mesure de température (3).

10. Utilisation du dispositif selon l'une quelconque des revendications 1 à 9 pour le réglage de la température de résonateurs de type optique ou électrique.
